Europäisches Patentamt

European Patent Office

Office européen des brevets

(11) Veröffentlichungsnummer: **0 237 114 B1**

# EUROPÄISCHE PATENTSCHRIFT

(45) Veröffentlichungstag der Patentschrift: **08.07.92**

(51) Int. Cl.⁵: **H01R 4/00**

(21) Anmeldenummer: **87200360.3**

(22) Anmeldetag: **02.03.87**

(54) **Verfahren zum Herstellen einer elektrisch leitenden Klebverbindung.**

(30) Priorität: **11.03.86 DE 3608010**

(43) Veröffentlichungstag der Anmeldung:
**16.09.87 Patentblatt 87/38**

(45) Bekanntmachung des Hinweises auf die
Patenterteilung:
**08.07.92 Patentblatt 92/28**

(84) Benannte Vertragsstaaten:
**DE FR GB NL**

(56) Entgegenhaltungen:
**DE-A- 2 856 368**
**US-A- 3 344 316**

**IBM TECHNICAL DISCLOSURE BULLETIN,
Band 28, Nr. 3, August 1985, Seiten
1272-1273; "Elastomeric module-to-board
connector system"**

(73) Patentinhaber: **Philips Patentverwaltung
GmbH
Wendenstrasse 35 Postfach 10 51 49
W-2000 Hamburg 1(DE)**

(84) Benannte Vertragsstaaten:
**DE**

(73) Patentinhaber: **N.V. Philips' Gloeilampenfabrieken
Groenewoudseweg 1
NL-5621 BA Eindhoven(NL)**

(84) Benannte Vertragsstaaten:
**FR GB NL**

(72) Erfinder: **Hieber, Hartmann, Dr.-Ing.
Brunsberg 24
W-2000 Hamburg 54(DE)**
Erfinder: **Thews, Wolfgang
Kiek Ut 16
W-2211 Wewelsfleth(DE)**

(74) Vertreter: **Kupfermann, Fritz-Joachim,
Dipl.-Ing. et al
Philips Patentverwaltung GmbH Wendenstrasse 35 Postfach 10 51 49
W-2000 Hamburg 1(DE)**

## Beschreibung

Die Erfindung betrifft ein Verfahren zum Herstellen einer elektrisch leitenden Klebverbindung zwischen elektrisch leitenden Teilen, deren zu verklebende Oberflächen eine Rauhtiefe aufweisen. Ein derartiges Verfahren ist aus der US-A-3 344 316 zu entnehmen.

In der Mikroelektronik werden elektrische Anschlüsse zwischen z.B. Bauelementen und Leiterplatten oder Zwischenträgern in Gestalt von Glas- oder Keramikplättchen durch Mikroschweißen, Weichlöten und Kleben hergestellt. Gegenüber dem nur sequentiell durchführbaren Mikroschweißen haben Löt- und Klebverfahren den Vorzug, daß alle Anschlüsse in einer Schaltungsebene praktisch gleichzeitig hergestellt werden können.

Klebverbindungen in der Mikroelektronik werden mit elektrisch leitenden Klebern ausgeführt, wobei die Kleber bis zu 70 Vol.% mit Metallpulver, beispielsweise Silberpulver, gefüllt werden, um sichere elektrische Anschlüsse zu erreichen. Der Kleber dient der mechanischen Verbindung zwischen den zu verklebenden Kontaktflächen; die im Kleber suspendierten Metallteilchen berühren sich gegenseitig und ermöglichen so eine Stromleitung.

Nachteilig bei der Verwendung von mit Metallpulver gefüllten Klebern ist das gezielte Anbringen bei kleinen Abmessungen der zu verklebenden Teile und außerdem die Gefahr möglicher Kurzschlüsse zwischen eng nebeneinander liegenden Anschlußflächen. Aus diesem Grund werden in der Mikroelektronik überwiegend Methoden des Weichlötens eingesetzt, die außerdem den wirtschaftlichen Vorteil haben, daß die erforderliche Beschichtung zu verlötender Oberflächen in Form von galvanischen Kupferschichten mit Zinnauflage einfach und auch bei kleinen Abmessungen reproduzierbar genau erfolgen kann und daß der Preis für im Handel erhältliche Weichlote relativ niedrig ist. Die Verarbeitung von mit Metallpulver gefüllten Klebern erfordert sehr gut vorgereinigte Oberflächen, und derartige Kleber sind relativ teuer. Der hohe Preis dieser Kleber beschränkt deren Anwendung auf sehr hochwertige und/oder temperaturempfindliche Schaltungsteile.

Der Erfindung liegt die Aufgabe zugrunde ein Verfahren anzugeben, mit dem elektrisch leitende Klebverbindungen auch bei kleinen Abmessungen der zu verklebenden Teile ohne Gefahr von Kurzschlüssen zwischen eng benachbart liegenden Kontaktstellen erreicht werden können und das gegenüber dem Klebverfahren mit mit Metallpulvern gefüllten Klebern erheblich kostengünstiger ist.

Diese Aufgabe wird erindungsgemäß dadurch gelöst, daß die zu verklebenden Oberflächen jeweils aus einer Schicht aus mindestens einem Übergangselement der ersten und/oder der zweiten Übergangsreihe des Periodischen Systems der Elemente (PSE) versehen werden, der eine Rauhtiefe im µm-Bereich erteilt wird, und daß für die Klebverbindung ein elektrisch nicht leitender Kleber in einer solchen Menge eingesetzt wird, daß die erhabenen Bereiche der Übergangselement-Schichten noch Kontakt miteinander erreichen.

Zu den Übergangselementen der ersten Übergangsreihe des Periodischen Systems der Elemente (PSE) gehören die Elemente Titan, Vanadium, Chrom, Mangan, Eisen, Kobalt, Nickel und Kupfer, zu den Übergangselementen der zweiten Übergangsreihe des PSE gehören die Elemente Zirkonium, Niob, Molybdän, Technetium, Ruthenium, Rhodium, Palladium und Silber. Diese Elemente können einzeln oder auch in Kombination miteinander zur Herstellung der Übergangselement-Schicht eingesetzt werden, wobei jeweils zwei Bauteile mit Übergangselement-Schichten aus gleichen Elementen, jedoch auch mit jeweils unterschiedlichen Elementen miteinander verklebt werden können.

Nach einer vorteilhaften Weiterbildung des Verfahrens nach der Erfindung wird als Kleber ein Kleblack, insbesondere auf Cyanacrylat-, Epoxidharz- oder Polyester-Basis eingesetzt. Zu den Kleblacken gehören alle flüssigen Klebstoffe, die organische Lösungsmittel enthalten. Es sind dies die verschiedenen Lösungen thermoplastischer Kunststoffe, aber auch Haftkleber auf der Grundlage von Polyisobutylen und Polyvinylether, sowie Kontaktkleber, die meist gelöste, synthetische Elastomere enthalten. Ebenso zählen zu den Kleblacken Reaktionskleblacke, die vorwiegend nur anpolymerisierte Kunststoffe enthalten wie Zweikomponentenkleber, bei denen ein Binder und ein Härter getrennt sind und erst vor dem Verkleben gemischt werden (z.B. Polymethacrylate, Polyurethan- und Epoxidharzvorprodukte, Polyethylenimine, ungesättigte Polyester) oder wie Einkomponentenkleber, die unter Einwirkung von Luftfeuchtigkeit vernetzen und so abbinden (Cyanacrylate und Isocyanat-Kleber).

Nach einer weiteren vorteilhaften Ausgestaltung des Verfahrens nach der Erfindung kann jedoch als Kleber auch ein Schmelzklebstoff eingesetzt werden. Hierzu gehören feste thermoplastische Kunststoffe in Form dünner Folien.

Grundsätzlich sind alle für das Verkleben von Metallen geeigneten Kleber einsetzbar, sofern sie niedrigviskos sind oder werden (z.B. durch Erwärmen), daß erhabene Bereiche der rauhen zu verklebenden Oberflächen noch miteinander Kontakt erhalten können.

Nach einer vorteilhaften Weiterbildung der Erfindung wird die Übergangselement-Schicht galvanisch abgeschieden. Hiermit ist der Vorteil verbunden, daß gängige Prozeßschritte, wie sie z.B. bei der Herstellung von Leiterplatten bei einer großtechnischen Fertigung angewendet werden, eingesetzt werden können. Ein solches Beschichtungsverfahren ist daher besonders kostengünstig.

Nach einer weiteren vorteilhaften Ausgestaltung des Verfahrens nach der Erfindung können die Übergangselement-Schichten auch durch Beschichtung mittels Kathodenzerstäubung hergestellt werden. Auf diese Weise können mit Vorteil Bauelemente mit einer Übergangselement-Schicht versehen werden.

Es ist jedoch auch möglich, durch Kathodenzerstäubung hergestellte oder z.B. aufgedampfte und anschließend z.B. durch einen Ionenätzprozeß aufgerauhte Zwischenschichten aus Metallegierungen, die die Funktion einer Haftschicht auf dem Substrat haben, galvanisch mit einer Übergangselement-Schicht zu verstärken.

Die gewünschte Rauhtiefe kann den zu verklebenden Oberflächen bereits vor dem Anbringen der Übergangselement-Schicht als auch im Verlauf des Anbringens der Übergangselement-Schicht erteilt werden, die gewünschte Rauhtiefe kann jedoch auch nach Anbringen der Übergangselement-Schicht hergestellt werden.

Vor und nach dem Anbringen der Übergangselement-Schicht kann die gewünschte Rauhtiefe z.B. durch einen Ionenätzprozeß erreicht werden. Bei dem galvanischen Abscheiden von Übergangselement-Schichten, jedoch auch bei dem Abscheiden mittels Kathodenzerstäubung hat es sich gezeigt, daß die dabei entstehende Rauhtiefe ausreicht, später elektrisch und mechanisch einwandfreie Verklebungen zu erreichen.

Das Entstehen der gewünschten Rauhtiefe hängt u.a. davon ab, welche Übergangselemente zum Herstellen der Übergangselement-Schicht eingesetzt werden, wie die Oberfläche des zu beschichtenden Substrates beschaffen ist und welche Prozesse zum Aufbringen der Übergangselement-Schicht eingesetzt werden. Hier liegt es im Bereich des fachmännischen Vorgehens, zu entscheiden, ob zusätzliche Maßnahmen zur Erreichung der gewünschten Rauhtiefe zu treffen sind, ob z.B. eine bereits abgeschiedene Übergangselement-Schicht noch z.B. durch einen anschließenden Ionenätzprozeß aufgerauht werden muß oder nicht.

Die mit der Erfindung erzielten Vorteile bestehen insbesondere darin, daß zur Herstellung elektrisch leitender Klebverbindungen auf mit Metallpulver gefüllte Kleber, deren Nachteile bereits dargestellt wurden, verzichtet werden kann.

Ein weiterer Vorteil ist, daß bei Anwendung eines elektrisch nicht leitenden Klebers auch strukturierte Oberflächen miteinander verklebt werden können dem Kleber die entsprechende Strukturierung erteilt werden müßte, d.h., ein elektrisch nicht leitender Kleber kann gleichmäßig über eine strukturierte Oberfläche verteilt werden, ohne die elektrischen Eigenschaften der Struktur zu verändern, was z.B. mit einem elektrisch leitenden Kleber nicht möglich ist.

Ein weiterer Vorteil ist, daß der Übergangswiderstand von nach dem vorliegenden Verfahren hergestellten Klebverbindungen bei gleichzeitiger mechanischer und thermischer Belastung klein ist, er liegt im Bereich von 3-9 m $\Omega$/mm$^2$ Kontaktfläche. Es hat sich gezeigt, daß der Übergangswiderstand erst bei einem Bruch der Klebverbindung ansteigt.

Im folgenden werden Ausführungsbeispiele der Erfindung beschrieben.

Beispiel I: Eine auf einem Siliciumsubstrat befindliche, etwa 0,5 $\mu$m dicke Goldschicht, die auf einer I00 nm dicken Haftschicht aus NiCr angebracht war und eine Rauhtiefe I00 nm hatte, wurde galvanisch mit einer Nickel-Schicht einer Dicke von $\approx$ 5 $\mu$m versehen. Dazu wurde das mit der Nickel-Chrom/Gold-Schichtenfolge versehene Substrat zunächst entfettet und in Wasser gespült, anschließend 30 min in I0%iger $H_2SO_4$ geätzt und abermals in Wasser gespült. Durch Elektrolyse wird dann die Nickelschicht aufgebracht aus einem wie folgt hergestellten Elektrolysebad:

Für die Herstellung von 0,I m$^3$ Elektrolyt werden in 0,06 m$^3$ deionisiertem Wasser einer Temperatur von 90°C 20 kg $NiSO_4.7 H_2O$ und 4 kg $NiCl_2.6 H_2O$ gelöst und die Lösung wird auf eine Temperatur von etwa 40°C abgekühlt. Anschließend werden 3 kg $H_3BO_3$ zugefügt und die Lösung wird mit deionisiertem Wasser auf 0,I m$^3$ aufgefüllt. Es werden I00 g Aktivkohle eingerührt. Nach Absetzen wird die Lösung filtriert und abermals auf 0,I m$^3$ aufgefüllt. Der pH-Wert der Lösung wird mittels $NH_4OH$ auf 5 eingestellt. Die elektrolytische Abscheidung einer $\approx$ 5 $\mu$m dicken Nickelschicht erfolgt über eine Dauer von 20 min bei einer Stromdichte von 2 A/dm$^2$ und einer Elektrolyttemperatur von etwa 45°C.

Die mit einer Rauhtiefe von $\approx$ I $\mu$m erhaltene Schicht wurde in etwa 2 mm breiten Streifen mit unterschiedlichen Klebern, wie einem Cyanacrylatkleber oder einem Zweikomponentenkleber auf Basis von Epoxidharz dünn bestrichen und mit einem ebenfalls mit einer Nickelschicht versehenen zweiten Substrat verklebt. Die Festigkeit der Klebverbindungen wurde durch einen Scherzugversuch mit folgenden Parametern geprüft:

Das System wurde dazu einer Scherzugbelastung in der Größe bis zu I N/mm$^2$ bei erhöhten Temperaturen unterworfen.

Die elektrische Leitfähigkeit der Klebverbindung wurde mit einem Stromdurchgang von 0,I A nach der Kelvin-Methode gemessen.

Unter den genannten Bedingungen hielt die Klebverbindung unter einer Belastung von I N/mm$^2$ bei Anwendung des Cyanacrylatklebers bei einer Temperatur von I50 bis I80°C etwa 2 h, bis sie brach; bei Anwendung eines aushärtenden Zweikomponentenklebers auf Epoxidharzbasis hielt die Klebverbindung bei einer Temperatur > 250 °C mehrere h. Der Übergangswiderstand der Klebverbindung schwankt mit der Zeit zwischen 3 und 9 m $\Omega$/mm² Kontaktfläche.

Beispiel 2: Auf einem Siliciumsubstrat wird durch Kathodenzerstäubung eine Kupferschicht einer Dicke von ≈ 1,5 $\mu$m abgeschieden.

Das zu beschichtende Substrat wird vor dem Abscheidungsprozeß gereinigt durch einen Ionenätzprozeß in einer Edelgasatmosphäre (vorzugsweise Argonatmosphäre) eines Drucks von ≈ 1 N/m² (10⁻⁵ bar) über eine Dauer von ≈ 1 min.

Der Targetkörper wird auf der Targetelektrode z.B. mit einem geeigneten Öl befestigt. Um Verlustwärme abzuführen, ist es zweckmäßig, z.B. durch Wasser gekühlte Targetelektroden zu verwenden.

Der Beschichtungsprozeß wird so durchgeführt, daß die Zerstäubungsapparatur zunächst mit einer Vakuumpumpe bis zu einem Druck von < 0,001 N/m² (10⁻⁸ bar) evakuiert wird, anschließend wird ein Edelgas, vorzugsweise Argon, eines Drucks von 5 N/m² (5.10⁻⁵ bar) eingeleitet. Die Niederschlagsrate liegt bei etwa 1 nm/s. Die Substrattemperatur beträgt > 250 °C. Die für den Aufbau des Plasmas erforderliche HF-Energie wird über die Targetelektrode eingespeist, wobei mit einer Gleichspannung von 1000 V zwischen Target-und Substratelektrode gearbeitet wird.

Nach dem Abscheiden wurden Kupferschichten einer Rauhtiefe von einigen 0,1 $\mu$m erhalten.

Derart beschichtete Substrate wurden wie zu Beispiel 1 beschrieben verklebt und die Festgkeit der Klebverbindungen wurde ebenfalls wie zu Beispiel 1 beschrieben geprüft. Die erhaltenen Prüfwerte lagen in der gleichen Größenordnung wie bei Beispiel 1.

Beispiel 3: Auf einem Siliciumsubstrat wird durch Kathodenzerstäubung eine Palladiumschicht einer Dicke im Bereich von ≈ 2 bis 5 $\mu$m abgeschieden.

Es ist zweckmäßig, das Substrat vor dem Abscheidungsprozeß zu reinigen; dies geschieht mittels eines Ionenätzprozesses in einer Edelgasatmosphäre (vorzugsweise Argonatmosphäre) eines Drucks von ≈ 1 N/m² (10⁻⁵ bar) über eine Dauer von ≈ 1 min.

Der Targetkörper aus Palladium wird auf der Targetelektrode z.B. mit einem geeigneten Öl befestigt. Um Verlustwärme abzuführen, ist es zweckmäßig, z.B. durch Wasser gekühlte Targetelektroden zu verwenden.

Der Beschichtungsprozeß wird so durchgeführt, daß die Zerstäubungsapparatur zunächst mit einer Vakuumpumpe bis zu einem Druck von < 0,001 N/m² (10⁻⁸ bar) evakuiert wird, anschließend wird ein Edelgas, vorzugsweise Argon, eines Drucks von ≈ 3 N/m² (3.10⁻⁵ bar) eingeleitet. Die Niederschlagsrate liegt bei etwa 1 nm/s. Die Substrattemperatur beträgt 150 bis 200 °C. Die für den Aufbau des Plasmas erforderliche HF-Energie wird über die Targetelektrode eingespeist, wobei mit ener Gleichspannung von 1000 V zwischen Target-und Substratelektrode gearbeitet wird.

Nach dem Abscheiden wurden Palladiumschichten mit relativ glatter Oberfläche erhalten, denen eine Rauhtiefe von ≈ 1 $\mu$m durch einen anschließenden Ionenätzprozeß erteilt wurde. Dazu wird das mit der Palladium-Schicht versehene Substrat auf der Targetelektrode einer HF-Kathodenzerstäubungsanlage befestigt und einem Ionenbeschuß aus einem Edelgasplasma eines Drucks von 1,3 N/m² (13.10⁻⁶ bar) bei einer Leistungsdichte von 100 W/dm² über eine Dauer von 20 min ausgesetzt.

Derart beschichtete Substrate wurden wie zu Beispiel 1 beschrieben verklebt und die Festigkeit der Klebverbindungen wurde ebenfalls wie zu Beispiel 1 beschrieben geprüft. Die erhaltenen Prüfwerte lagen in der gleichen Größenordnung wie bei Beispiel 1.

**Patentansprüche**

1. Verfahren zum Herstellen einer elektrisch leitenden Klebverbindung zwischen elektrisch leitenden Teilen, deren zu verklebende Oberflächen eine Rauhtiefe aufweisen,
dadurch gekennzeichnet,
daß die zu verklebenden Oberflächen jeweils mit einer Schicht aus mindestens einem Übergangselement der ersten und/oder der zweiten Übergangsreihe des Periodischen Systems der Elemente (PSE) versehen werden, der eine Rauhtiefe im $\mu$m-Bereich erteilt wird, und daß für die Klebverbindung ein elektrisch nicht leitender Kleber in einer solchen Menge eingesetzt wird, daß die erhabenen Bereiche der Übergangselement-Schichten noch Kontakt miteinander erreichen.

2. Verfahren nach Anspruch 1,
dadurch gekennzeichnet,
daß für die Herstellung der Übergangselement-Schicht mindestens ein Element aus der Gruppe Titan, Vanadium, Chrom, Mangan, Eisen, Kobalt, Nickel und/oder Kupfer gewählt wird.

3. Verfahren nach Anspruch 1,
dadurch gekennzeichnet,
daß für die Herstellung der Übergangselement-Schicht mindestens ein Element aus der Gruppe Zirkonium, Niob, Molybdän, Technetium, Ruthenium, Rhodium, Palladium und/oder Silber gewählt wird.

4. Verfahren nach Anspruch 1,

dadurch gekennzeichnet,
daß als Kleber ein Kleblack eingesetzt wird.

5. Verfahren nach Anspruch 4,
dadurch gekennzeichnet,
daß ein Kleber auf Cyanacrylat-Basis eingesetzt wird.

6. Verfahren nach Anspruch 4,
dadurch gekennzeichnet,
daß ein Kleber auf Epoxidharz-Basis eingesetzt
wird.

7. Verfahren nach Anspruch 4,
dadurch gekennzeichnet,
daß ein Kleber auf Polyester-Basis eingesetzt
wird.

8. Verfahren nach Anspruch I,
dadurch gekennzeichnet,
daß als Kleber ein Schmelzklebstoff eingesetzt
wird.

9. Verfahren nach den Ansprüchen I bis 3,
dadurch gekennzeichnet,
daß die Übergangselement-Schicht galvanisch
auf den zu verklebenden Oberflächen abgeschieden wird.

10. Verfahren nach den Ansprüchen I bis 3,
dadurch gekennzeichnet,
daß die Übergangselement-Schicht durch Kathodenzerstäubung aufgebracht wird.

11. Verfahren nach mindestens einem der Ansprüchen I bis 10,
dadurch gekennzeichnet,
daß den zu verklebenden Oberflächen die gewünschte Rauhtiefe erteilt wird und anschließend die Übergangselement-Schicht angebracht wird.

12. Verfahren nach Anspruch 11
dadurch gekennzeichnet,
daß den zu verklebenden Oberflächen die gewünschte Rauhtiefe mit Aufbringen der
Übergangselement-Schicht erteilt wird.

13. Verfahren nach Anspruch 11,
dadurch gekennzeichnet,
daß den zu verklebenden Oberflächen die gewünschte Rauhtiefe nach dem Aufbringen der
Übergangselement-Schicht erteilt wird.

14. Verfahren nach den Ansprüchen II bis I3,
dadurch gekennzeichnet,
daß den zu verklebenden Oberflächen die gewünschte Rauhtiefe durch einen Ionenätzprozeß erteilt wird.

15. Anwendung des Verfahrens nach den Ansprüchen I bis I4 zur Fertigung von Bauteilen der
Mikroelektronik.

**Claims**

1. A method of manufacturing an electrically conductive adhesive bond between electrically
conductive parts whose surfaces to be bonded
exhibit a certain degree of surface roughness,
characterized in that the surfaces to be bonded
are each provided with a layer of at least one
transition element of the first and/or second
transition series of the periodic system of elements (PSE), to which layer a surface roughness in the $\mu$m range is imparted, and in that
to form the adhesive bond a quantity of an
electrically non-conductive adhesive is used
such that the raised portions of the transition-
element-layers are still in contact with each
other.

2. A method as claimed in Claim 1, characterized
in that for the manufacture of the transition-
element-layer at least one element of the
group formed by titanium, vanadium, chromium, manganese, iron, cobalt, nickel and/or
copper is selected.

3. A method as claimed in Claim 1, characterized
in that for the manufacture of the transition-
element-layer at least one element of the
group made up of zirconium, niobium, molybdenum, technetium, ruthenium, rhodium, palladium and/or silver is selected.

4. A method as claimed in Claim 1, characterized
in that an adhesive lacquer is used as an
adhesive.

5. A method as claimed in Claim 4, characterized
in that an adhesive based on cyanoacrylate is
used.

6. A method as claimed in Claim 4, characterized
in that an adhesive based on epoxy resin is
used.

7. A method as claimed in Claim 4, characterized
in that an a adhesive based on polyester is
used.

8. A method as claimed in Claim 1, characterized
in that a hot-melt adhesive is used.

9. A method as claimed in Claims 1 to 3, characterized in that the transition-element-layer is deposited on the surfaces to be bonded by means of an electrodeposition process.

10. A method as claimed in Claims 1 to 3, characterized in that the transition-element-layer is applied by cathode sputtering.

11. A method as claimed in at least one of the Claims 1 to 10, characterized in that the desired surface roughness is imparted to the surfaces to be bonded, after which the transition-element-layer is applied.

12. A method as claimed in Claim 11, characterized in that by the application of the transition-element-layer the desired surface roughness is imparted to the surfaces to be bonded.

13. A method as claimed in Claim 11, characterized in that the desired surface roughness is imparted to the surfaces to be bonded after the transition-element-layer has been applied.

14. A method as claimed in Claims 11 to 13, characterized in that the desired surface roughness is imparted to the surfaces to be bonded by means of an ion-etching process.

15. The use of the method as claimed in Claims 1 to 14 for the manufacture of microelectronic components.

**Revendications**

1. Procédé pour la réalisation d'une connexion adhésive électriquement conductrice entre des parties électriquement conductrices dont les surfaces à coller présentent une profondeur de rugosité, caractérisé en ce que les surfaces à coller sont munies chaque fois d'une couche en au moins un élément de transition de la première rangée de transition et/ou de la deuxième rangée de transition de la Classification périodique des éléments chimiques auquel est conférée une profondeur de rugosité dans la gamme de $\mu$m, et en ce qu'une colle électriquement non conductrice est utilisée pour la connexion adhésive dans une quantité telle que les zones en relief des couches d'élément de transition sont encore en contact l'une avec l'autre.

2. Procédé selon la revendication 1, caractérisé en ce que pour la réalisation de la couche d'élément de transition, on choisit au moins un élément du groupe
titane, vanadium, chrome, manganèse, fer, cobalt, nickel et/ou cuivre.

3. Procédé selon la revendication 1, caractérisé en ce que pour la réalisation de la couche d'élément de transition, on choisit au moins un élément du groupe
zirconium, niobium, molybdène, technétium, ruthénium, rhodium, palladium et/ou argent.

4. Procédé selon la revendication 1, caractérisé en ce que comme colle on utilise un vernis adhésif.

5. Procédé selon la revendication 4, caractérisé par l'utilisation d'une colle à base de cyanacrylate.

6. Procédé selon la revendication 4, caractérisé par l'utilisation d'une colle à base de résine époxy.

7. Procédé selon la revendication 4, caractérisé par l'utilisation d'une colle à base de polyester.

8. Procédé selon la revendication 1, caractérisé en ce que la colle est une colle à fusion.

9. Procédé selon les revendications 1 à 3, caractérisé en ce que la couche d'élément de transition est déposée par voie galvanique sur les surfaces à assembler.

10. Procédé selon les revendications 1 à 3, caractérisé en ce que la couche d'élément de transition est appliquée par pulvérisation cathodique.

11. Procédé selon au moins l'une des revendications précédentes 1 à 10, caractérisé en ce qu'aux surfaces à assembler est conférée la profondeur de rugosité requise, après quoi on applique la couche d'élément de transition.

12. Procédé selon la revendication 11, caractérisé en ce qu'aux surfaces à assembler est conférée la profondeur de rugosité requise pendant l'application de la couche d'élément de transition.

13. Procédé selon la revendication 11, caractérisé en ce qu'aux surfaces à assembler est conférée la profondeur de rugosité requise après l'application de la couche d'élément de transition.

14. Procédé selon les revendications 11 à 13, caractérisé en ce qu'aux surfaces à assembler est conférée la profondeur de rugosité requise par un processus de décapage ionique.

**15.** Application du procédé selon les revendications 1 à 14 pour la fabrication de composants de la microélectronique.